# EUROPEAN PATENT APPLICATION

(11) **EP 4 195 270 A1**
(43) Date of publication of application: **14.06.2023**
(21) Application number: 22194344.2
(22) Date of filing: 07.09.2022
(51) Int. Cl.: H01L 27/02, H01L 23/528, H01L 27/118

(54) **SEMICONDUCTOR INTEGRATED CIRCUITS**

(30) Priority: 07.12.2021 JP 2021198589
(71) Applicant: Kioxia Corporation, Tokyo 108-0023 (JP)
(72) Inventor: MAENO, Muneaki, Tokyo (JP); KOHARA, Koji, Tokyo (JP)
(74) Representative: Hoffmann Eitle

(57) **Abstract**

According to a certain embodiment, the semiconductor integrated circuit includes: first and second power source lines disposed to extend in a first direction; a third power source line disposed in parallel to the first power supply line in a second direction, and having an electric potential equivalent to that of the second power source line; a fourth power source line disposed in parallel to the second power supply line and having an electric potential equivalent to that of the first power source line; a first transistor disposed below the first power supply line and including a first active region; a second transistor disposed below the second power source line and including a second active region; a third transistor disposed between the first active region and the third power source line and including a third active region; and a fourth transistor including a fourth active region.

## Description

### FIELD

Embodiments described herein relate generally to a semiconductor integrated circuit.

### BACKGROUND

There has been a standard cell layout for forming semiconductor integrated circuits on semiconductor substrates with high integration as designing methods (layout techniques). The standard cell layout is a layout in which a functional circuit of basic units, such as an inverter a NAND element that has been designed and verified in advance is prepared as a standard cell, and a metallic wiring layer is formed thereon, to design an integrated circuit chip. For the standard cell, for example, a pattern layout called a double height cell or a triple height cell is used. In the double height cell, an unused region may occur due to a pattern arrangement. In such an unused region, an insulation layer may be filled or a filler cell having a dummy transistor may be disposed.

### BRIEF DESCRIPTION OF THE DRAWINGS

Fig. 1 is a planar pattern configuration diagram illustrating a semiconductor integrated circuit according to a first embodiment.
Fig. 2A is a cross-sectional diagram taken in the line I-I of Fig. 1.
Fig. 2B is a cross-sectional diagram taken in the line II-II of Fig. 1.
Fig. 3A is a cross-sectional diagram taken in the line III-III of Fig. 1.
Fig. 3B is a cross-sectional diagram taken in the line IV-IV (VII-VIII) of Fig. 1.
Fig. 3C is a cross-sectional diagram taken in the line V-V (IX-IX) of Fig. 1.
Fig. 3D is a cross-sectional diagram taken in the line VI-VI of Fig. 1.
Fig. 3E is a cross-sectional diagram taken in the line VII-VII of Fig. 1.
Fig. 3F is a cross-sectional diagram taken in the line X-X of Fig. 1.
Fig. 4 is a planar pattern configuration diagram illustrating a semiconductor integrated circuit according to a second embodiment.
Fig. 5 is a cross-sectional diagram taken in the line XI-XI of Fig. 4.
Fig. 6A is a planar pattern configuration diagram illustrating a semiconductor integrated circuit according to a third embodiment.
Fig. 6B is a planar pattern configuration diagram of a semiconductor integrated circuit according to a modified example of the third embodiment.
Fig. 7 is a cross-sectional diagram taken in the line XII-XII of Figs. 6A and 6B.
Fig. 8 is a planar pattern configuration diagram illustrating a semiconductor integrated circuit according to a fourth embodiment.
Fig. 9 is a circuit representation of the semiconductor integrated circuit according to the fourth embodiment.
Fig. 10A is a cross-sectional diagram taken in the line XIII-XIII of Fig. 8.
Fig. 10B is a cross-sectional diagram taken in the line XIV-XIV of Fig. 8.
Fig. 11A is an explanatory diagram illustrating a current path in a case of providing a high level signal in Fig. 8.
Fig. 11B is an explanatory diagram illustrating a current path in a case of providing a low level signal in Fig. 8.
Fig. 11C is an explanatory diagram illustrating a suppressing operation of an electromigration (EM) in Fig. 8.
Fig. 12 is a planar pattern configuration diagram illustrating a semiconductor integrated circuit according to a comparative example.
Fig. 13 shows a circuit representation of the semiconductor integrated circuit according to the comparative example.
Fig. 14A is an explanatory diagram of a current path in a case of providing a high level signal in Fig. 13.
Fig. 14B is an explanatory diagram of a current path in a case of providing a low level signal in Fig. 13.

### DETAILED DESCRIPTION

Next, certain embodiments will now be explained with reference to drawings. In the description of the following specification or drawings to be explained, the identical or similar reference sign is attached to the identical or similar part. However, the drawings are merely schematic. Moreover, the embodiments described hereinafter merely exemplify a device and/or a method for materializing the technical idea. The embodiments may be changed without departing from the spirit or scope of claims. In the following description, a Metal Oxide Semiconductor (MOS) transistor may be represented as a MOS, a p channel MOS transistor may be represented as a PMOS, and an n channel MOS transistor may be represented as an NMOS. Moreover, a p type well diffusion region may be represented as a Pwell, and an n type well diffusion region may be represented as an Nwell. Moreover, an active region of PMOS may be represented as P+ (PMOS), and an active region of NMOS may be represented as N+ (NMOS). Moreover, a source region, drain region, and a channel region of the MOS are included in the active region, but are not distinguished from one another. Moreover, a gate oxide film formed between the active region and a control electrode is not illustrated in the drawings.

Certain embodiments provide a semiconductor integrated circuit having improved area efficiency of a cell pattern in a standard cell.

According to one embodiment, a semiconductor integrated circuits includes: in a standard cell where power source lines and active regions are disposed, a first power supply line and a second power source line disposed to extend in a first direction and to be separated from each other; a third power source line disposed to be adjacent to and in parallel to the first power supply line in a second direction orthogonal to the first direction, the third power source line having an electric potential equivalent to that of the second power source line; a fourth power source line disposed to be adjacent to and in parallel to the second power supply line in a minus direction of the second direction, the fourth power source line having an electric potential equivalent to that of the first power source line; a first transistor disposed below the first power supply line, first transistor including a first conductivity-type first active region extending in the second direction and the minus direction of the second direction; a second transistor disposed below the second power source line, the second transistor including a second conductivity-type second active region extending in the second direction and the minus direction of the second direction; a third transistor disposed between the first active region and the third power source line, the third transistor including a second conductivity-type third active region; and a fourth transistor disposed between the second active region and the fourth power source line, the fourth transistor including a first conductivity-type fourth active region.

### (First Embodiment)

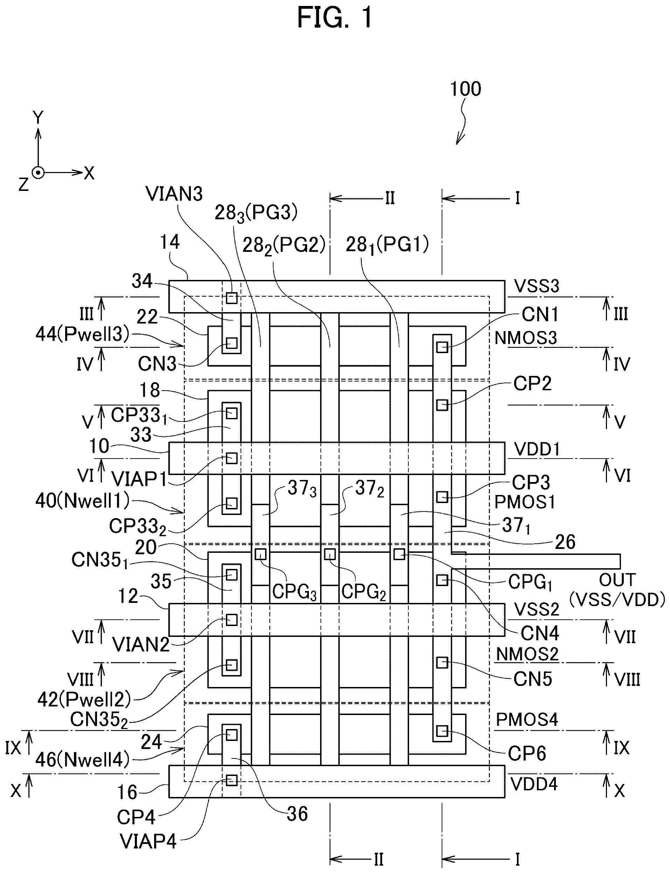

Fig. 1 is a planar pattern configuration diagram illustrating a semiconductor integrated circuit 100 according to a first embodiment. The semiconductor integrated circuit 100 according to the first embodiment constitutes a logic circuit of a triple height standard cell. In Fig. 1, a first direction is defined as an X direction, a second direction orthogonal to the first direction is defined as a Y direction, and a third direction orthogonal to an X-Y plane is defined as a Z direction. The double height cell is a cell in which two cells are overlapped in a channel width direction so that an area for arranging a transistor can be secured more than twice compared to that of the single height cell. The triple height cell is a cell in which three cells are overlapped in a channel width direction so that an area for arranging a transistor can be secured three times or more compared to that of the single height cell.

As illustrated in Fig. 1, the semiconductor integrated circuit 100 according to the first embodiment includes a first power supply line (VDD1) 10, a second power source line (VSS2) 12, a third power supply line (VSS3) 14, and a fourth power supply line (VDD4) 16. The first power supply line (VDD1) 10 and the second power source line (VSS2) 12 are disposed to extend in the X direction and to be separated from each other. The third power source line (VSS3) 14 is disposed to be adjacent to and in parallel to the first power supply line 10 in the Y direction orthogonal to the X direction, and has an electric potential equivalent to that of the second power source line 12. The fourth power source line (VDD4) 16 is disposed to be adjacent to and in parallel to the second power source line 12 in a minus Y direction (negative Y direction), and has an electric potential equivalent to that of the first power supply line 10.

As illustrated in Fig. 1, the semiconductor integrated circuit 100 according to the first embodiment includes a first transistor PMOS1, a second transistor NMOS2, a third transistor NMOS3, and a fourth transistor PMOS4. The first transistor PMOS1 is disposed below (i.e., in the minus Z direction of ) the first power supply line 10. The first transistor PMOS1 includes a first conductivity-type first active region 18 disposed to extend in the Y direction and the minus Y direction. The second transistor NMOS2 is disposed below (i.e., in the minus Z direction of) the second power source line 12. The second transistor NMOS2 includes a second conductivity-type second active region 20 disposed to extend in the Y direction and the minus Y direction. The third transistor NMOS3 is disposed between the first active region 18 and the third power source line 14 and includes a second conductivity-type third active region 22. The fourth transistor PMOS4 is disposed between the second active region 20 and the fourth power source line 16 and includes a first conductivity-type fourth active region 24.

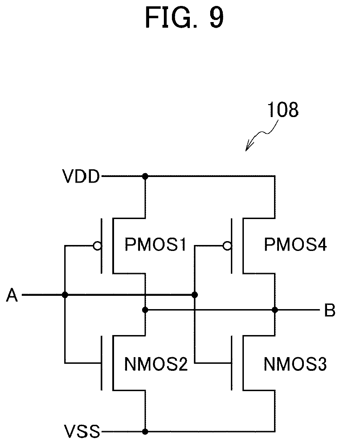

As illustrated in Fig. 1, the semiconductor integrated circuit 100 according to the first embodiment includes an electrode 34, an electrode 36, an electrode 33, and an electrode 35, each extending in the Y direction. The electrode 34 electrically connects between the third active region 22 and the third power source line 14. The electrode 36 electrically connects between the fourth active region 24 and the fourth power source line 16. The electrode 34 is electrically connected to the third active region 22 through a contact electrode CN3. The electrode 36 is electrically connected to the fourth active region 24 through a contact electrode CP4. The electrode 34 is further electrically connected to the third power source line 14 through a VIA electrode VIAN3. The electrode 36 is electrically connected to the fourth power source line 16 through a VIA electrode VIAP4. The electrode 33 is electrically connected to the first active region 18 through contact electrodes CP33₁ and CP33₂. The electrode 35 is electrically connected to the second active region 20 through contact electrodes CN35₁ and CN35₂. The electrode 33 is further electrically connected to the first power supply line 10 through a VIA electrode VIAP1. The electrode 35 is electrically connected to the second power source line 12 through a VIA electrode VIAN2. With the above-described configuration, a source, which is one of main electrodes of each the first transistor PMOS1 and the fourth transistor PMOS4 is connected to a power supply voltage VDD, and a source, which is one of main electrodes of each the second transistor NMOS2 and the third transistor NMOS3 is connected to a power supply voltage VSS. The semiconductor integrated circuit 100 according to the first embodiment can be represented as a parallel circuit between a first CMOS inverter composed of the first transistor PMOS1 and the second transistor NMOS2 and a second CMOS inverter composed of the fourth transistor PMOS4 and the third transistor NMOS3, as in a circuit representation of Fig. 9 described below.

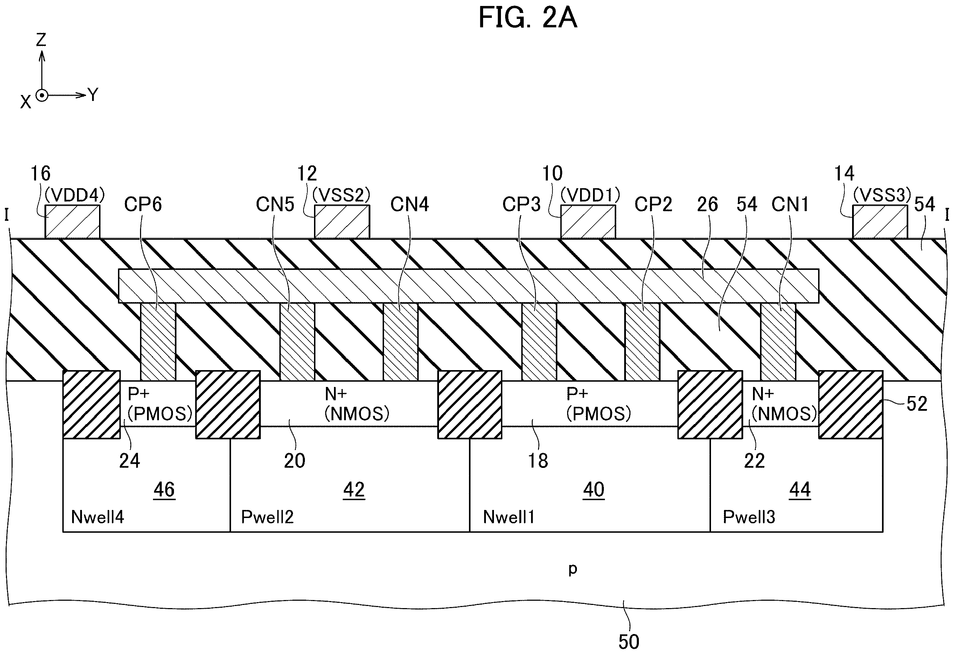

Fig. 2A is a cross-sectional diagram taken in the line I-I of Fig. 1. Fig. 2A corresponds to a structure cut along a common electrode 26 extending in the Y direction.

As illustrated in Figs. 1 and 2A, the semiconductor integrated circuit 100 according to the first embodiment includes a common electrode 26 connecting the first active region 18, the second active region 20, the third active region 22, and the fourth active region 24. The common electrode 26 is disposed to extend in the Y direction. An output of the logic circuit in the semiconductor integrated circuit 100 according to the first embodiment is obtained from the common electrode 26. The common electrode 26 can be formed of a metal layer. The common electrode 26 and the first active region 18 are connected to each other through contact electrodes CP2 and CP3. The common electrode 26 and he second active region 20 are connected to each other through contact electrodes CN4 and CN5. The common electrode 26 and the third active region 22 are connected to each other through a contact electrode CN1. The common electrode 26 and the fourth active region 24 are connected to each other through a contact electrode CP6. With the above-described configuration, a drain, which is the other of the main electrodes of each the first transistor PMOS1 and the fourth transistor PMOS4 is connected to the common electrode 26, and a drain, which is the other of main electrodes of each the second transistor NMOS2 and the third transistor NMOS3 is also connected to the common electrode 26. In addition, the common electrode 26 is connected to an output OUT as illustrated in Fig. 1.

As illustrated in Figs. 1 and 2A, an insulation layer 52 is disposed each between the first active region 18 and the third active region 22, between the second active region 20 and the fourth active region 24, and between the first active region 18 and the second active region 20. The insulation layer 52 is an insulation layer for insulating and separating the regions from each other, and can be formed by, for example, Shallow Trench Isolation (STI). Moreover, the insulation layer 52 is disposed also each between the substrate 50 and the third active region 22 and between the substrate 50 and the fourth active region 24.

Moreover, as illustrated in Figs. 1 and 2A, the semiconductor integrated circuit 100 according to the first embodiment includes a substrate 50, a second conductivity-type first well region (Nwell1) 40 disposed on the substrate 50 and including the first active region 18, a first conductivity-type second well region (Pwell2) 42 disposed on the substrate 50 and including the second active region 20, a first conductivity-type third well region (Pwell3) 44 disposed on the substrate 50 and including the third active region 22, and a second conductivity-type fourth well region (Nwell4) 46 disposed on the substrate 50 and including the fourth active region 24. In addition, the substrate 50 is formed of, for example, a first conductivity-type semiconductor.

As illustrated in Fig. 2A, with respect to the substrate 50, the common electrode 26 is disposed as a first metal layer, and the first power supply line 10, the second power source line 12, the third power source line 14, and the fourth power source line 16 are disposed as a second metal layer. An interlayer insulation film 54 is disposed each between the substrate 50 and the common electrode 26 and between the substrate 50 and the first power supply line 10, the second power source line 12, the third power source line 14, and the fourth power source line 16. The interlayer insulation film 54 can be formed of, for example, an insulation layer, such as an oxide film, a nitride film, and tetraethoxysilane (TEOS).

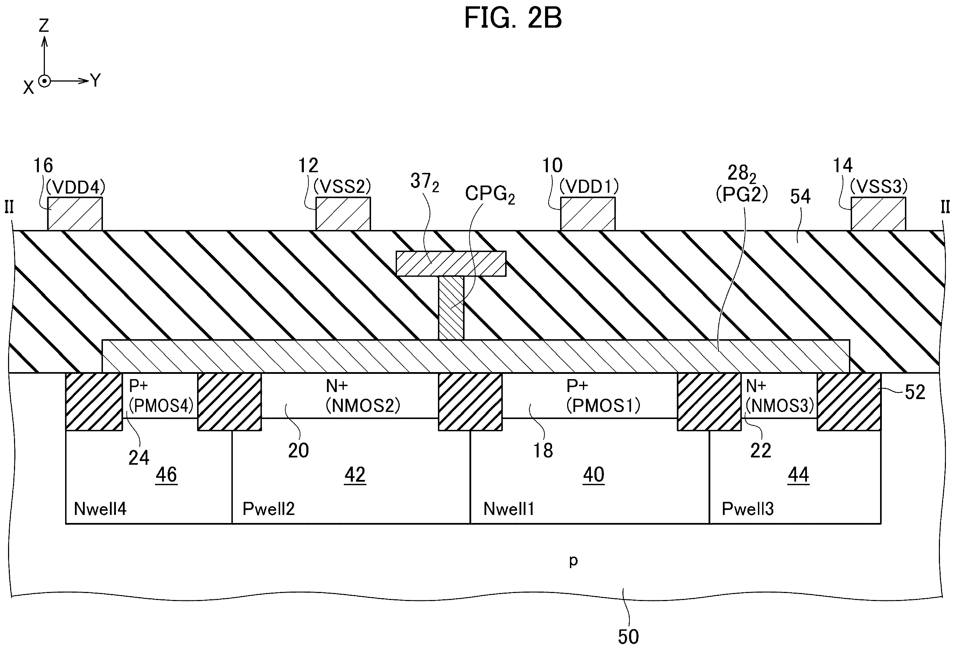

Fig. 2B is a cross-sectional diagram taken in the line II-II of Fig. 1. Fig. 2B corresponds to a structure cut along a control electrode (PG2) 28₂ extending in the Y direction.

As illustrated in Figs. 1 and 2B, the semiconductor integrated circuit 100 according to the first embodiment includes the control electrode (PG2) 28₂ disposed to extend in the Y direction on the first active region 18, the second active region 20, the third active region 22, and the fourth active region 24. Moreover, as illustrated in Fig. 2B, a contact electrode CPG₂ is disposed on the control electrode 28₂. Furthermore, an input electrode 37₂ is disposed on the contact electrode CPG₂. It is to be noted that a gate oxide film formed between the control electrode (PG2) 28₂, and the first active region 18, the second active region 20, the third active region 22, and the fourth active region 24 is not illustrated in the drawings. The first transistor PMOS1 includes the first active region 18 and the control electrode 28₂. The second transistor NMOS2 includes the second active region 20 and the control electrode 28₂. The third transistor NMOS3 includes the third active region 22 and the control electrode 28₂. The fourth transistor PMOS4 includes the fourth active region 24 and the control electrode 28₂.

Moreover, as illustrated in Fig. 1, there may be included a control electrode (PG1) 28₁ and a control electrode (PG3) 28₃, disposed to extend in the Y direction and to be adjacent to and in parallel to the control electrode 28₂. In other words, a plurality of the control electrodes may be disposed to extending in the Y direction and in parallel to each other. The semiconductor integrated circuit 100 according to the first embodiment can constitute an inverter, for example, when the number of the control electrodes is one. When the number of the control electrodes is two, a two-input NAND gate can be constituted, for example. The control electrode 28₁, the control electrode 28₂, and the control electrode 28₃ are formed of, for example, a polysilicon layer. It is to be noted that a gate oxide film is formed between the control electrodes 28₁ and 28₃, and the first active region 18, the second active region 20, the third active region 22, and the fourth active region 24. As illustrated in Figs. 1 and 2B, the semiconductor integrated circuit 100 according to the first embodiment includes contact electrodes CPG₁, CPG₂, and CPG₃ respectively disposed on the control electrodes 28₁, 28₂ and 28₃, and input electrodes 37₁, 37₂, and 37₃ respectively disposed on the contact electrodes CPG₁, CPG₂, and CPG₃. The input electrodes 37₁, 37₂, and 37₃ are respectively electrically connected to the control electrodes 28₁, 28₂, and 28₃ respectively through the contact electrodes CPG₁, CPG₂, and CPG₃.The input electrodes 37₁, 37₂, and 37₃ may be configured as separate inputs for the respective control electrodes 28₁, 28₂, and 28₃. For example, in the case of the inverter configuration, when voltage VDD (VSS) is supplied to the input electrodes 37₁, 37₂, and 37₃, voltage VSS (VDD) is obtained in the output OUT.

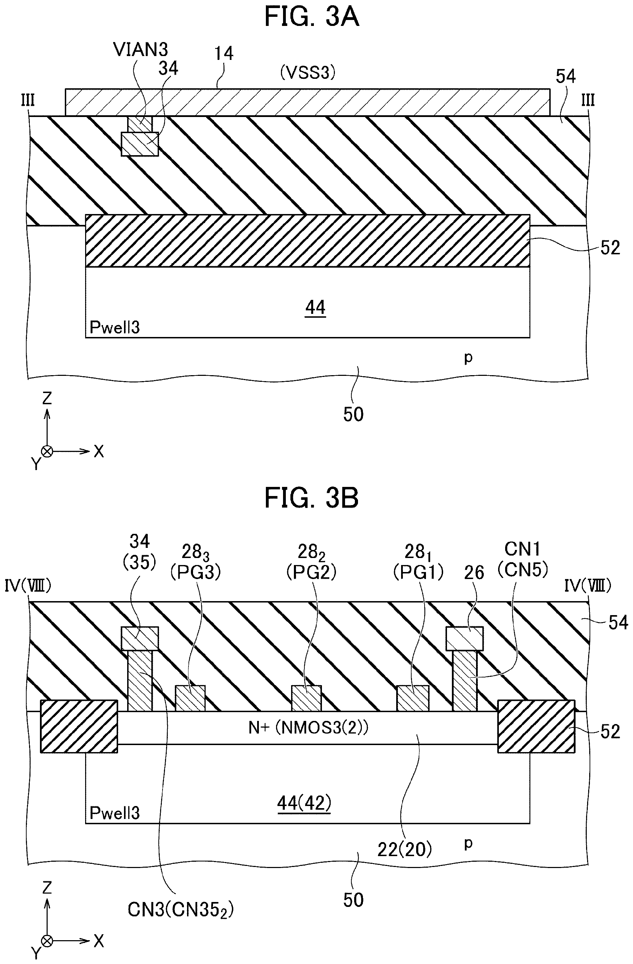

Fig. 3A is a cross-sectional diagram taken in the line III-III of Fig. 1. Fig. 3A corresponds to a structure cut along the third power source line 14 extending in the X direction. As illustrated in Figs. 1 and 3A, the semiconductor integrated circuit 100 according to the first embodiment includes the substrate 50, the third well region 44 disposed on the substrate 50, the insulation layer 52 disposed on the third well region 44, and the third power source line 14 disposed on the insulation layer 52 through an interlayer insulation film 54. As illustrated in Fig. 3A, the electrode 34 is embedded in the interlayer insulation film 54, and the electrode 34 is electrically connected to the third power source line 14 through the VIA electrode VIAN3. The electrode 34 is disposed as the first metal layer.

Fig. 3B is a cross-sectional diagram taken in the line IV-IV of Fig. 1. Fig. 3B corresponds to a structure cut along the third active region 22 extending in the X direction. As illustrated in Figs. 1 and 3B, the semiconductor integrated circuit 100 according to the first embodiment includes the substrate 50, the third well region 44 disposed on the substrate 50, the third active region 22 disposed on the third well region 44, the control electrode 28₁, the control electrode 28₂, the control electrode 28₃, the contact electrode CN1, and contact electrode CN3 which are disposed on the third active region 22, the common electrode 26 disposed on the contact electrode CN1, and the electrode 34 disposed on the contact electrode CN3. It is to be noted that a gate oxide film formed between the control electrodes 28₁, 28₂, and 28₃ and the third active region 22 is not illustrated in the drawings. The third active region 22 is separated from the substrates 50 by the insulation layer 52. Moreover, the interlayer insulation film 54 is disposed on the third active region 22.

A cross-sectional diagram taken in the line VIII-VIII of Fig. 1 is similarly illustrated to that of Fig. 3B. Accordingly, Fig. 3B corresponds also to a structure cut along the second active region 20 extending in the X direction. As illustrated in Figs. 1 and 3B, the semiconductor integrated circuit 100 according to the first embodiment includes the substrate 50, the second well region 42 disposed on the substrate 50, the second active region 20 disposed on the second well region 42, the control electrode 28₁, the control electrode 28₂, the control electrode 28₃, the contact electrode CN5, and the contact electrode CN35₂ which are disposed on the second active region 20, the common electrode 26 disposed on the contact electrode CN5, and a electrode 35 disposed on the contact electrode CN35₂. The second active region 20 is separated from the substrates 50 by the insulation layer 52. Moreover, the interlayer insulation film 54 is disposed on the second active region 20.

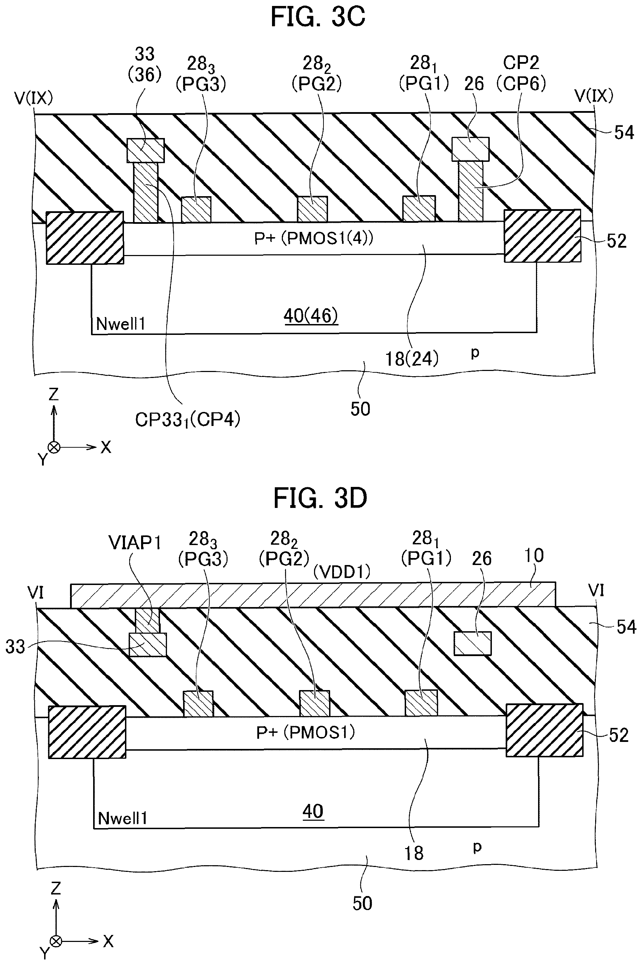

Fig. 3C is a cross-sectional diagram taken in the line V-V of Fig. 1. Fig. 3C corresponds to a structure cut along the first active region 18 extending in the X direction. As illustrated in Figs. 1 and 3C, the semiconductor integrated circuit 100 according to the first embodiment includes the substrate 50, the first well region 40 disposed on the substrate 50, the first active region 18 disposed on the first well region 40, the control electrode 28₁, the control electrode 28₂, the control electrode 28₃, the contact electrode CP2, and the contact electrode CP33₁ which are disposed on the first active region 18, the common electrode 26 disposed on the contact electrode CP2, and the electrode 33 disposed on the contact electrode CP33₁. It is to be noted that a gate oxide film formed between the control electrodes 28₁, 28₂, and 28₃ and the first active region 18 is not illustrated in the drawings. The first active region 18 is separated from the substrates 50 by the insulation layer 52. Moreover, the interlayer insulation film 54 is disposed on the first active region 18.

A cross-sectional diagram taken in the line IX-IX of Fig. 1 is similarly illustrated to that of Fig. 3C. Accordingly, Fig. 3C corresponds also to a structure cut along the fourth active region 24 extending in the X direction. As illustrated in Figs. 1 and 3C, the semiconductor integrated circuit 100 according to the first embodiment includes the substrate 50, the fourth well region 46 disposed on the substrate 50, the fourth active region 24 disposed on the fourth well region 46, the control electrode 28₁, the control electrode 28₂, the control electrode 28₃, the contact electrode CP6, and the contact electrode CP4 which are disposed on the fourth active region 24, the common electrode 26 disposed on the contact electrode CP6, and the electrode 36 disposed on the contact electrode CP4. The fourth active region 24 is separated from the substrates 50 by the insulation layer 52. Moreover, the interlayer insulation film 54 is disposed on the fourth active region 24.

Fig. 3D is a cross-sectional diagram taken in the line VI-VI of Fig. 1. Fig. 3D corresponds to a structure cut along the first power supply line 10 which extends in the X direction. As illustrated in Figs. 1 and 3D, the semiconductor integrated circuit 100 according to the first embodiment includes the substrate 50, the first well region 40 disposed on the substrate 50, the first active region 18 disposed on the first well region 40, and the control electrode 28₁, the control electrode 28₂, and the control electrode 28₃ which are disposed on the first active region 18. It is to be noted that a gate oxide film formed between the control electrodes 28₁, 28₂, and 28₃ and the first active region 18 is not illustrated in the drawings. The first active region 18 is separated from the substrates 50 by the insulation layer 52. Moreover, the interlayer insulation film 54 is disposed on the first active region 18. In the interlayer insulation film 54, the common electrode 26 is disposed as the first metal layer. Furthermore, the first power supply line 10 is disposed as the second metal layer on the interlayer insulation film 54. Moreover, the electrode 33 is disposed as the first metal layer in the interlayer insulation film 54. Furthermore, the VIA electrode VIAP1 is disposed on the electrode 33 and is connected to the first power supply line 10.

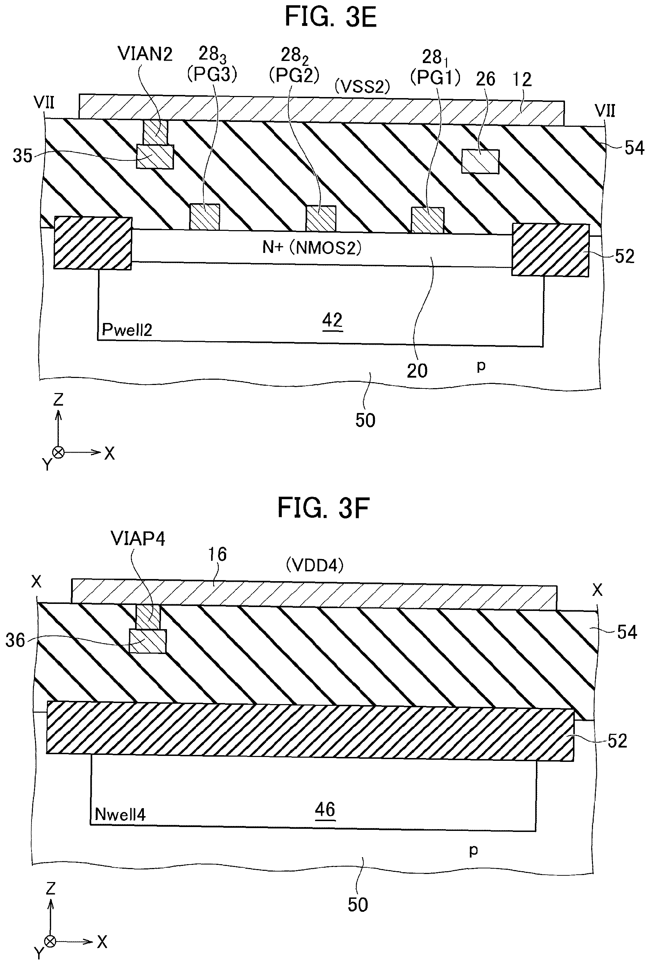

Fig. 3E is a cross-sectional diagram taken in the line VII-VII of Fig. 1. Fig. 3E corresponds to a structure cut along the second power source line 12 extending in the X direction. As illustrated in Figs. 1 and 3E, the semiconductor integrated circuit 100 according to the first embodiment includes the substrate 50, the second well region 42 disposed on the substrate 50, the second active region 20 disposed on the second well region 42, and the control electrode 28₁, the control electrode 28₂, and the control electrode 28₃ which are disposed on the second active region 20. It is to be noted that a gate oxide film formed between the control electrodes 28₁, 28₂, and 28₃ and the second active region 20 is not illustrated in the drawings. The second active region 20 is separated from the substrates 50 by the insulation layer 52. Moreover, the interlayer insulation film 54 is disposed on the second active region 20. In the interlayer insulation film 54, the common electrode 26 is disposed as the first metal layer. Furthermore, the second power supply line 12 is disposed as the second metal layer on the interlayer insulation film 54. Moreover, the electrode 35 is disposed as the first metal layer in the interlayer insulation film 54.Furthermore, the VIA electrode VIAN2 is disposed on the electrode 35 and is connected to the second power supply line 12.

Fig. 3F is a cross-sectional diagram taken in the line X-X of Fig. 1. Fig. 3F corresponds to a structure cut along the fourth power source line 16 extending in the X direction. As illustrated in Figs. 1 and 3F, the semiconductor integrated circuit 100 according to the first embodiment includes the substrate 50, the fourth well region 46 disposed on the substrate 50, the insulation layer 52 disposed on the fourth well region 46, and the fourth power source line 16 disposed on the insulation layer 52 through the interlayer insulation film 54. Moreover, the electrode 36 is disposed as the first metal layer in the interlayer insulation film 54. Furthermore, the VIA electrode VIAP4 is disposed on the electrode 36 and is connected to the fourth power supply line 16.

The semiconductor integrated circuit 100 according to the first embodiment forms a triple-height cell structure by disposing the third transistor NMOS3 and the fourth transistor PMOS4 with respect to the double-height cell structure composed of the first transistor PMOS1 and the second transistor NMOS2. The third transistor NMOS3 is disposed between the first active region 18 and the third power source line 14 and includes a second conductivity-type third active region 22. The fourth transistor PMOS4 is disposed between the second active region 20 and the fourth power source line 16 and includes a first conductivity-type fourth active region 24. Accordingly, an unused region that is an inactive region in the double-height cell structure can be used as the third active region 22 and the fourth active region 24, thereby improving area efficiency of the cell pattern in the standard cell.

Furthermore, as illustrated in Fig. 1, the first transistor PMOS1 includes the first conductivity-type first active region 18 disposed below the first power source line 10 so as to extend in the Y direction and the minus Y direction. The second transistor NMOS2 includes the second conductivity-type second active region 20 disposed below the second power source line 12 so as to extend in the Y direction and the minus Y direction. In the first transistor PMOS1, a portion of the first active region 18 disposed below the first power supply line 10 also contributes to the gate width, and in the second transistor NMOS2, a portion of the second active region 20 disposed below the second power source line 12 also contributes to the gate width. Accordingly, comparing the gate widths of the transistors, the gate widths of the first transistor PMOS1 and the second transistor NMOS2 are approximately 3 times larger than the gate widths of the third transistor NMOS3 and the fourth transistor PMOS4. Accordingly, in the semiconductor integrated circuit 100 according to the first embodiment, the effective gate widths of the first transistor PMOS1 and the second transistor NMOS2 can be increased, and thereby the driving capability can be increased.

### (Effects of First Embodiment)

The semiconductor integrated circuit according to the first embodiment can improve the area efficiency of the cell pattern in the standard cell.

### (Second Embodiment)

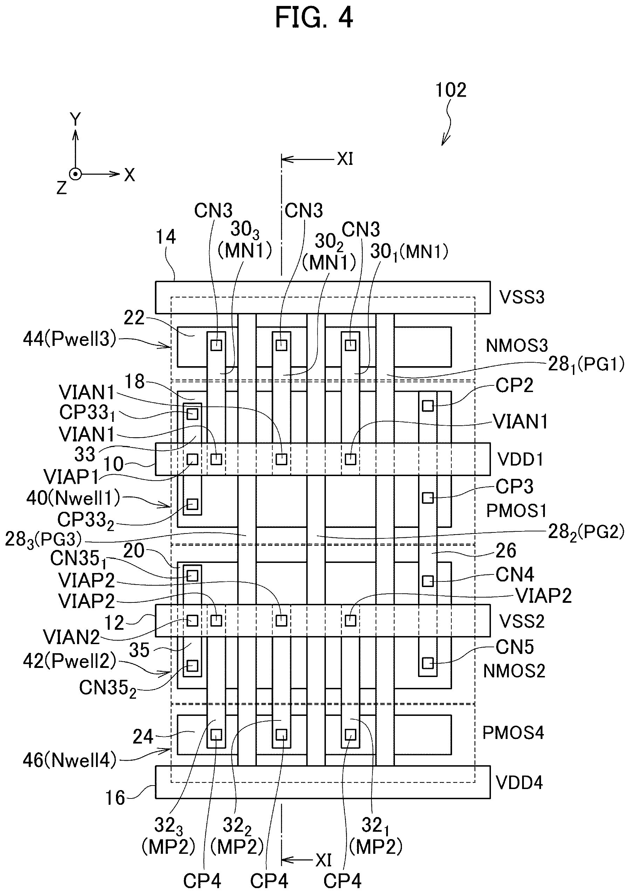

Fig. 4 is a planar pattern configuration diagram illustrating a semiconductor integrated circuit 102 according to a second embodiment. In the following description, component parts different from that of the semiconductor integrated circuit 100 according to the first embodiment will be described, and the description of the same component parts will be omitted. The input electrodes 37₁, 37₂, and 37₃ and the output OUT are represented in the same way as that in Fig. 1, and illustration thereof is omitted in Fig. 4.

As illustrated in Fig. 4, the semiconductor integrated circuit 102 according to the second embodiment includes electrodes (MN1) 30₁ to 30₃ and electrodes (MP2) 32₁ to 32₃. The electrodes 30₁ to 30₃ extend in the Y direction in parallel to each other to electrically connect between the third active region 22 and the first power supply line 10. The electrodes 32₁ to 32₃ extend in the Y direction in parallel to each other to electrically connect between the fourth active region 24 and the second power supply line 12. Moreover, the semiconductor integrated circuit 102 according to the second embodiment includes an electrode 33 and an electrode 35, each extending in the Y direction, as illustrated in Fig. 4. The electrode 33 is electrically connected to the first active region 18 through contact electrodes CP33₁ and CP33₂. The electrode 35 is electrically connected to the second active region 20 through contact electrodes CN35₁ and CN35₂. The electrode 33 is further electrically connected to the first power supply line 10 through a VIA electrode VIAP1. The electrode 35 is electrically connected to the second power source line 12 through a VIA electrode VIAN2. With the above-described configuration, a source, which is one of main electrodes of the first transistor PMOS1 is connected to a power supply voltage VDD, and a source, which is one of main electrodes of the second transistor NMOS2 is connected to a power supply voltage VSS. A drain, which is the other of the main electrodes of the first transistor PMOS1 is connected to a common electrode 26, and a drain, which is the other of the main electrodes of the second transistor NMOS2 is also connected to the common electrode 26.

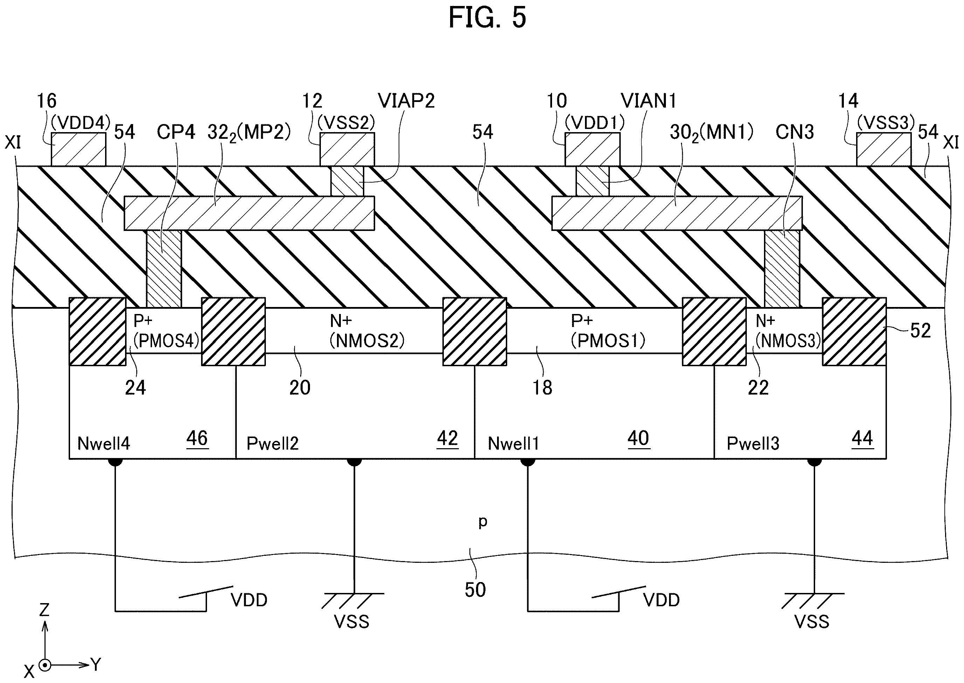

Fig. 5 is a cross-sectional diagram taken in the line XI-XI of Fig. 4. As illustrated in Figs. 4 and 5, the semiconductor integrated circuit 102 according to the second embodiment includes a substrate 50, and a first well region 40, a second well region 42, a third well region 44, and a fourth well region 46, each disposed on the substrate 50. The first active region 18 is disposed on the first well region 40. The second active region 20 is disposed on the second well region 42. The third active region 22 is disposed on the third well region 44. The fourth active region 24 is disposed on the fourth well region 46.

Furthermore, as illustrated in Figs. 4 and 5, the semiconductor integrated circuit 102 according to the second embodiment includes the contact electrode CN3 disposed on the third active region 22, and the contact electrode CP4 disposed on the fourth active region 24. The electrode 30₂ is disposed on the contact electrode CN3. The electrode 32₂ is disposed on the contact electrode CP4.

As illustrated in Figs. 4 and 5, the semiconductor integrated circuit 102 according to the second embodiment includes a VIA electrode VIAN1 disposed on the electrode 30₂, a VIA electrode VIAP2 disposed on the electrode 32₂, the first power supply line 10 disposed on the VIA electrode VIAN1, and the second power source line 12 disposed on the VIA electrode VIAP2.

The third active region 22 is electrically connected to the electrode 30₂ through the contact electrode CN3. The fourth active region 24 is electrically connected to the electrode 32₂ through the contact electrode CP4. The electrode 30₂ is electrically connected to the first power supply line 10 through the VIA electrode VIAN1. The electrode 32₂ is electrically connected to the second power source line 12 through the VIA electrode VIAP2.

Moreover, as illustrated in Fig. 4, the semiconductor integrated circuit 102 according to the second embodiment includes control electrodes 28₁, 28₂, and 28₃, disposed to extend in the Y direction and in parallel to one another on the first active region 18, the second active region 20, the third active region 22, and the fourth active region 24. The first transistor PMOS1 includes the first active region 18 and the control electrodes 28₁, 28₂, and 28₃. The second transistor NMOS2 includes the second active region 20 and the control electrodes 28₁, 28₂, and 28₃. The third transistor NMOS3 includes the third active region 22 and the control electrodes 28₁, 28₂, and 28₃. The fourth transistor PMOS4 includes the fourth active region 24 and the control electrodes 28₁, 28₂, and 28₃.

As illustrated in Figs. 4 and 5, the semiconductor integrated circuit 102 according to the second embodiment includes the insulation layer 52 for isolation disposed each between the first active region 18 and the second active region 20, between the first active region 18 and the third active region 22, and between the second active region 20 and the fourth active region 24. Moreover, the insulation layer 52 is disposed also each between the substrate 50 and the third active region 22 and between the substrate 50 and the fourth active region 24.

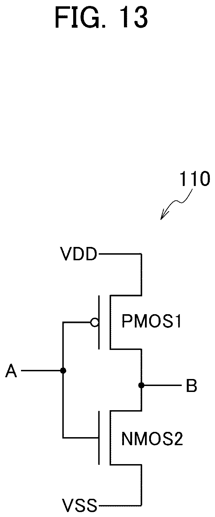

Moreover, as illustrated in Fig. 4, the semiconductor integrated circuit 102 according to the second embodiment includes the common electrode 26 connecting between the first active region 18 and the second active region 20. An output of the logic circuit in the semiconductor integrated circuit 102 according to the second embodiment is obtained from the common electrode 26. The common electrode 26 and the first active region 18 are connected to each other through the contact electrodes CP2 and CP3. The common electrode 26 and the second active region 20 are connected to each other through the contact electrodes CN4 and CN5. The semiconductor integrated circuit 102 according to the second embodiment can be represented as a Complementary MOS (CMOS) inverter composed of the first transistor PMOS1 and the second transistor NMOS2, similar to the circuit representation illustrated in Fig. 13 described below.

Moreover, with respect to the substrate 50, the common electrode 26, the electrodes 30₁ to 30₃, and the electrodes 32₁ to 32₃ are disposed as a first metal layer, and the first power supply line 10, the second power source line 12, the third power source line 14, and the fourth power source line 16 are disposed as a second metal layer. The interlayer insulation film 54 is disposed each between the substrate 50 and the common electrode 26 and between the substrate 50 and the first power supply line 10, the second power source line 12, the third power source line 14, and the fourth power source line 16.

### (Capacitor)

In the semiconductor integrated circuit 102 according to the second embodiment, as illustrated in Fig. 5, the first well region 40 and the fourth well region 46 are connected to the voltage VDD having an electric potential equivalent to the first power supply line 10 and the fourth power source line 16, and the second well region 42 and the third well region 44 are connected to the voltage VSS having an electric potential equivalent to the second power source line 12 and the third power source line 14. As a result, the third active region 22 forms a first capacitor composed of a pn junction between the third active region 22 and the third well regions 44. Moreover, the fourth active region 24 forms a second capacitor composed of a pn junction between the fourth active region 24 and the fourth well regions 46. More specifically, in the semiconductor integrated circuit 102 according to the second embodiment, the capacitors are respectively connected to the first power supply line 10 and the second power source line 12 which are disposed in the center in the Y direction in the standard cell.

The semiconductor integrated circuit 102 according to the second embodiment forms a triple-height cell structure by disposing the third transistor NMOS3 and the fourth transistor PMOS4 with respect to the double-height cell structure composed of the first transistor PMOS1 and the second transistor NMOS2. Furthermore, the first capacitor and the second capacitor are respectively formed in the disposition regions of the third active region 22 and the fourth active region 24. Accordingly, an unused region that is an inactive region in the double-height cell structure can be used as the third active region 22 and the fourth active region 24 and also can be used as the disposition regions of the capacitors, thereby improving area efficiency of the cell pattern in the standard cell. In other words, for example, capacitors that are separately disposed in other spaces, in a block of logic where a plurality of standard cells in the XY direction, are disposed can be efficiently disposed in the cell pattern of the standard cell, thereby improving area efficiency. It is to be noted that the third power source line 14 and the fourth power source line 16 are not be connected in the semiconductor integrated circuit 102 according to the second embodiment, and therefore may be removed as long as they are unnecessary for a layout wiring program etc. Moreover, in Fig. 4, the electrodes 30₁ to 30₃ and 33, the electrodes 32₁ to 32₃ and 35, the VIA electrodes VIAN1 and VIAP1, and the VIA electrodes VIAP2 and VIAN2 illustrated as separate electrodes are each connected to the same power supply voltage, and therefore may also be commonalized.

In the semiconductor integrated circuit according to the second embodiment, the capacitor is inserted between the power supply and the ground in the standard cell and the electric current can be supplied from the capacitor with respect to an internal rapid peak current, and thereby power supply voltage drop can be suppressed and fluctuation of power supply can be reduced.

### (Effects of Second Embodiment)

The semiconductor integrated circuit according to the second embodiment can improve the area efficiency of the cell pattern in the standard cell. Moreover, the circuit speed and operational stability can be improved by disposing the capacitors in the standard cell.

### (Third Embodiment)

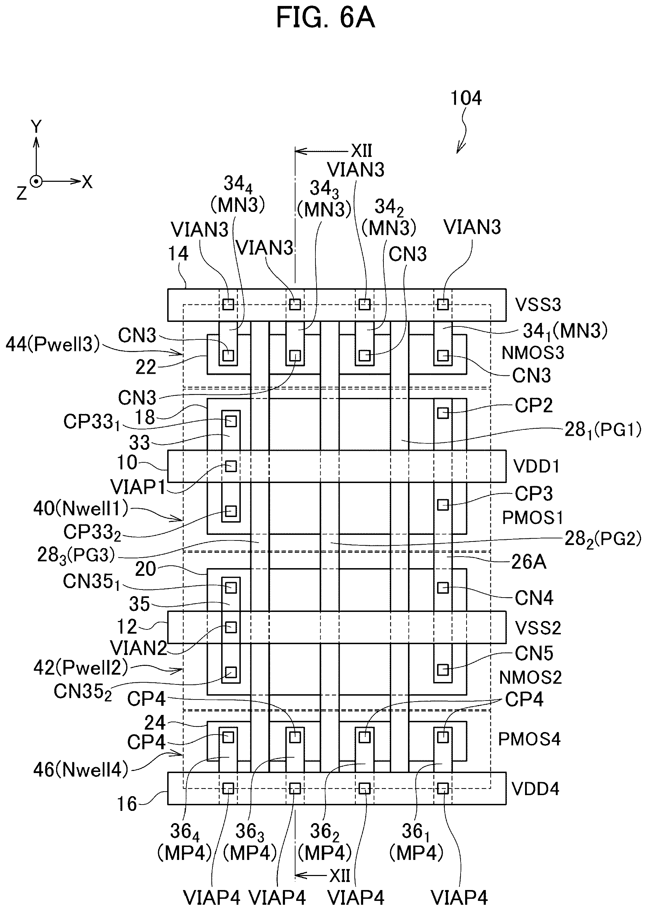

Fig. 6A is a planar pattern configuration diagram illustrating a semiconductor integrated circuit 104 according to a third embodiment. In the following description, component parts different from that of the semiconductor integrated circuit 100 according to the first embodiment will be described, and the description of the same component parts will be omitted. The input electrodes 37₁, 37₂, and 37₃ and the output OUT are represented in the same way as that in Fig. 1, and illustration thereof is omitted in Fig. 6A.

As illustrated in Fig. 6A, the semiconductor integrated circuit 104 according to the third embodiment includes electrodes (MN3) 34₁ to 34₄ and electrodes (MP4) 36₁ to 36₄, each extending in the Y direction. The electrodes 34₁ to 34₄ extend in the Y direction in parallel to each other to electrically connect between the third active region 22 and the third power supply line 14. The electrodes 36₁ to 36₄ extend in the Y direction in parallel to each other to electrically connect between the fourth active region 24 and the fourth power supply line 16. Moreover, as illustrated in Fig. 6A, the semiconductor integrated circuit 104 according to the third embodiment includes the electrode 33 and the electrode 35, each extending in the Y direction. The electrode 33 is electrically connected to the first active region 18 through contact electrodes CP33₁ and CP33₂. The electrode 35 is electrically connected to the second active region 20 through contact electrodes CN35₁ and CN35₂. The electrode 33 is further electrically connected to the first power supply line 10 through a VIA electrode VIAP1. The electrode 35 is electrically connected to the second power source line 12 through a VIA electrode VIAN2. With the above-described configuration, a source, which is one of main electrodes of the first transistor PMOS1 is connected to a power supply voltage VDD, and a source, which is one of main electrodes of the second transistor NMOS2 is connected to a power supply voltage VSS. A drain, which is the other of the main electrodes of the first transistor PMOS1 is connected to the common electrode 26, and a drain, which is the other of the main electrodes of the second transistor NMOS2 is also connected to the common electrode 26.

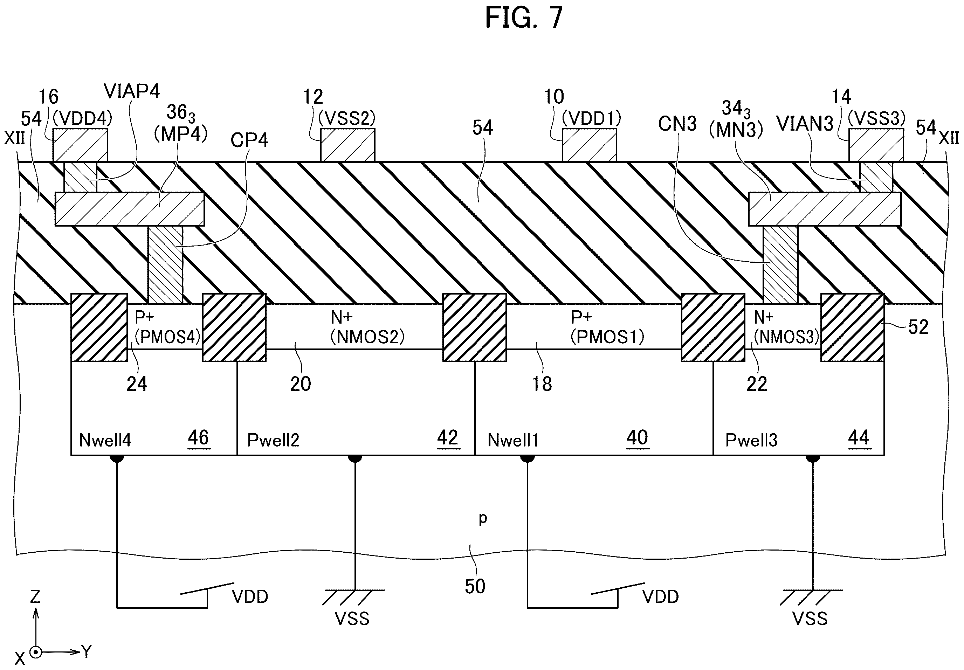

Fig. 7 is a cross-sectional diagram taken in the line XII-XII of Fig. 6A. As illustrated in Figs. 6A and 7, the semiconductor integrated circuit 104 according to the third embodiment includes a substrate 50, and a first well region 40, a second well region 42, a third well region 44, and a fourth well region 46, each disposed on the substrate 50. The first active region 18 is disposed on the first well region 40. The second active region 20 is disposed on the second well region 42. The third active region 22 is disposed on the third well region 44. The fourth active region 24 is disposed on the fourth well region 46.

Furthermore, as illustrated in Figs. 6A and 7, the semiconductor integrated circuit 104 according to the third embodiment includes the contact electrodes CN3 disposed on the third active region 22, and the contact electrodes CP4 disposed on the fourth active region 24. The electrodes 34₁ to 34₄ are respectively disposed on the contact electrodes CN3. The electrodes 36₁ to 36₄ are respectively disposed on the contact electrodes CP4.

Furthermore, as illustrated in Figs. 6A and 7, the semiconductor integrated circuit 104 according to the third embodiment includes VIA electrodes VIAN3 respectively disposed on the electrodes 34₁ to 34₄, VIA electrodes VIAP4 respectively disposed on the electrodes 36₁ to 36₄, the third power source line 14 disposed on the VIA electrodes VIAN3, and the fourth power source line 16 disposed on the VIA electrodes VIAP4.

The third active region 22 is electrically connected respectively to the electrodes 34₁ to 34₄ respectively through the contact electrodes CN3. The fourth active region 24 is electrically connected respectively to the electrodes 36₁ to 36₄ respectively through the contact electrodes CP4. The electrodes 34₁ to 34₄ are electrically connected to the third power source line 14 respectively through the VIA electrodes VIAN3. The electrodes 36₁ to 36₄ are electrically connected to the fourth power source line 16 respectively through the VIA electrodes VIAP4.

Moreover, as illustrated in Fig. 6A, the semiconductor integrated circuit 104 according to the third embodiment includes control electrodes 28₁, 28₂, and 28₃, disposed to extend in the Y direction and in parallel to one another on the first active region 18, the second active region 20, the third active region 22, and the fourth active region 24. The first transistor PMOS1 includes the first active region 18 and the control electrodes 28₁, 28₂, and 28₃. The second transistor NMOS2 includes the second active region 20 and the control electrodes 28₁, 28₂, and 28₃. The third transistor NMOS3 includes the third active region 22 and the control electrodes 28₁, 28₂, and 28₃. The fourth transistor PMOS4 includes the fourth active region 24 and the control electrodes 28₁, 28₂, and 28₃.

Moreover, as illustrated in Figs. 6A and 7, the semiconductor integrated circuit 104 according to the third embodiment includes the insulation layer 52 disposed each between the first active region 18 and the second active region 20, between the first active region 18 and the third active region 22, and between the second active region 20 and the fourth active region 24. Moreover, the insulation layer 52 is disposed also each between the substrate 50 and the third active region 22 and between the substrate 50 and the fourth active region 24.

Moreover, as illustrated in Fig. 6A, the semiconductor integrated circuit 104 according to the third embodiment includes a common electrode 26A connecting between the first active region 18 and the second active region 20. An output of the logic circuit in the semiconductor integrated circuit 104 according to the third embodiment is obtained from the common electrode 26A. The common electrode 26A and the first active region 18 are connected to each other through the contact electrode CP2 and CP3. The common electrode 26A and the second active region 20 are connected to each other through the contact electrodes CN4 and CN5. The semiconductor integrated circuit 104 according to the third embodiment can be represented as a CMOS inverter composed of the first transistor PMOS1 and the second transistor NMOS2, similar to the circuit representation illustrated in Fig. 13 described below.

Moreover, with respect to the substrate 50, the common electrode 26A, the electrodes 34₁ to 34₄, and the electrodes 36₁ to 36₄ are disposed as a first metal layer, and the first power supply line 10, the second power source line 12, the third power source line 14, and the fourth power source line 16 are disposed as a second metal layer. An interlayer insulation film 54 is disposed each between the substrate 50 and the common electrode 26 and between the substrate 50 and the first power supply line 10, the second power source line 12, the third power source line 14, and the fourth power source line 16.

### (Capacitor)

As illustrated in Fig. 7, in the semiconductor integrated circuit 104 according to the third embodiment, the first well region 40 and the fourth well region 46 are connected to the voltage VDD having an electric potential equivalent to the first power supply line 10 and the fourth power source line 16, and the second well region 42 and the third well region 44 are connected to the voltage VSS having an electric potential equivalent to the second power source line 12 and the third power source line 14. As a result, the third active region 22 forms a third capacitor composed of a pn junction between the third active region 22 and the third well regions 44. Moreover, the fourth active region 24 forms a fourth capacitor composed of a pn junction between the fourth active region 24 and the fourth well regions 46. More specifically, in the semiconductor integrated circuit 104 according to the third embodiment, the capacitors are respectively connected to the third power source line 14 and the fourth power source line 16 which are disposed at upper and lower sides in the Y direction in the standard cell.

The semiconductor integrated circuit 104 according to the third embodiment forms a triple-height cell structure by disposing the third transistor NMOS3 and the fourth transistor PMOS4 with respect to the double-height cell structure composed of the first transistor PMOS1 and the second transistor NMOS2. Furthermore, the third capacitor and the fourth capacitor are respectively formed in the disposition regions of the third active region 22 and the fourth active region 24. Accordingly, an unused region that is an inactive region in the double-height cell structure can be used as the third active region 22 and the fourth active region 24 and also can be used as the disposition regions of the capacitors, thereby improving area efficiency of the cell pattern in the standard cell.

### (Effects of Third Embodiment)

The semiconductor integrated circuit according to the third embodiment can improve the area efficiency of the cell pattern in the standard cell. Moreover, the circuit speed and operational stability can be improved by disposing the capacitors in the standard cell.

### (Modified Example of Third Embodiment)

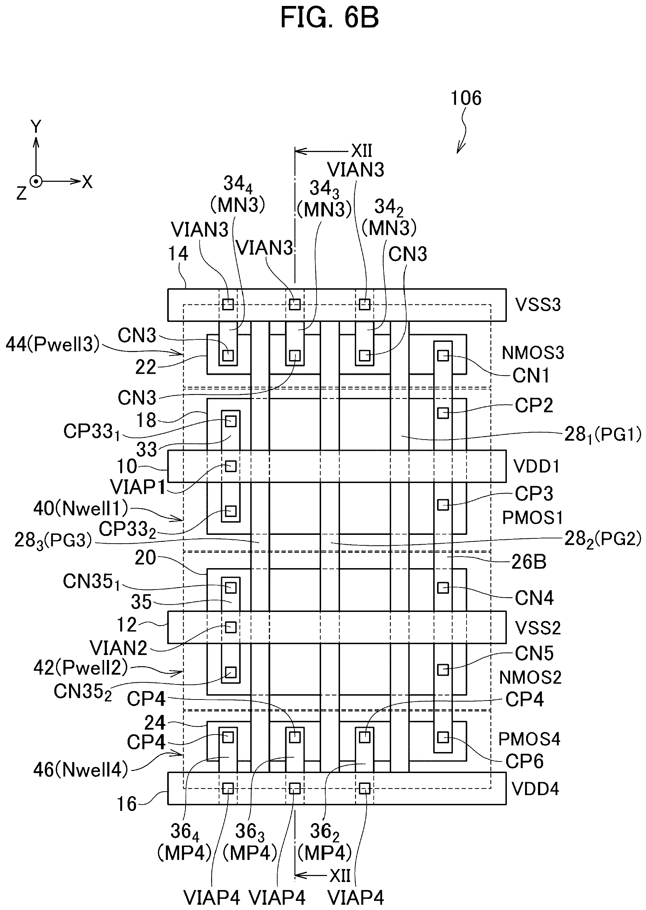

Fig. 6B is a planar pattern configuration diagram illustrating a semiconductor integrated circuit 106 according to a modified example of the third embodiment. In the following description, component parts different from that of the semiconductor integrated circuit 104 according to the third embodiment will be described, and the description of the same component parts will be omitted. The input electrodes 37₁, 37₂, and 37₃ and the output OUT are represented in the same way as that in Fig. 1, and illustration thereof is omitted in Fig. 6B.

As illustrated in Fig. 6B, the semiconductor integrated circuit 106 according to the modified example of the third embodiment includes electrodes 34₂ to 34₄, each extending in the Y direction and electrically connecting between the third active region 22 and the third power source line 14, and electrodes 36₂ to 36₄, each extending in the Y direction and electrically connecting between the fourth active region 24 and the fourth power source line 16.

Moreover, as illustrated in Fig. 6B, the semiconductor integrated circuit 106 according to the modified example of the third embodiment includes a common electrode 26B connecting the first active region 18, the second active region 20, the third active region 22, and the fourth active region 24. The common electrode 26B and the first active region 18 are electrically connected to each other through the contact electrodes CP2 and CP3. The common electrode 26B and the second active region 20 are electrically connected to each other through the contact electrodes CN4 and CN5. The common electrode 26B and the third active region 22 are electrically connected to each other through a contact electrode CN1. The common electrode 26B and the fourth active region 24 are electrically connected to each other through a contact electrode CP6. The semiconductor integrated circuit 106 according to the modified example of the third embodiment can be represented as a parallel circuit between a first CMOS inverter composed of the first transistor PMOS1 and the second transistor NMOS2 and a second CMOS inverter composed of the fourth transistor PMOS4 and the third transistor NMOS3, as in the circuit representation of Fig. 9 described below.

In the semiconductor integrated circuit 106 according to the modified example of the third embodiment, the cross-sectional diagram taken in the line XII-XII of Fig. 6B is also the same as that of Fig. 7, and therefore the description of the cross-sectional structure thereof is omitted. Moreover, in the semiconductor integrated circuit 106 according to the modified example of the third embodiment, a cross-sectional structure taken in the Y direction along the common electrode 26B is the same as the cross-sectional structure taken in the line I-I of Fig. 1, i.e., Fig. 2A.

Also in the semiconductor integrated circuit 106 according to the modified example of the third embodiment, the first well region 40 and the fourth well region 46 are connected to the voltage VDD having an electric potential equivalent to the first power supply line 10 and the fourth power source line 16, and the second well region 42 and the third well region 44 are connected to the voltage VSS having an electric potential equivalent to the second power source line 12 and the third power source line 14.

### (Capacitor)

Similar to the semiconductor integrated circuit 104 according to the third embodiment, also in the semiconductor integrated circuit 106 according to the modified example of the third embodiment, the third active region 22 includes a third capacitor composed of a pn junction between the third active region 22 and the third well regions 44, and the fourth active region 24 includes a fourth capacitor composed of a pn junction between the fourth active region 24 and the fourth well regions 46. More specifically, also in the semiconductor integrated circuit 106 according to the modified example of the third embodiment, the capacitors are respectively connected to the third power source line 14 and the fourth power source line 16 which are disposed at upper and lower sides in the Y direction in the standard cell.

The semiconductor integrated circuit 106 according to the modified example of the third embodiment forms a triple-height cell structure by disposing the third transistor NMOS3 and the fourth transistor PMOS4 with respect to the double-height cell structure composed of the first transistor PMOS1 and the second transistor NMOS2. Furthermore, the third capacitor and the fourth capacitor can be respectively formed in the disposition regions of the third active region 22 and the fourth active region 24. Accordingly, an unused region that is an inactive region in the double-height cell structure can be used as the third active region 22 and the fourth active region 24 and also can be used as the disposition regions of the capacitors, thereby improving area efficiency of the cell pattern in the standard cell.

### (Effects of Modified Example of Third Embodiment)

The semiconductor integrated circuit according to the modified example of the third embodiment can improve the area efficiency of the cell pattern in the standard cell. Moreover, the circuit speed and operational stability can be improved by disposing the capacitors in the standard cell.

### (Fourth Embodiment)

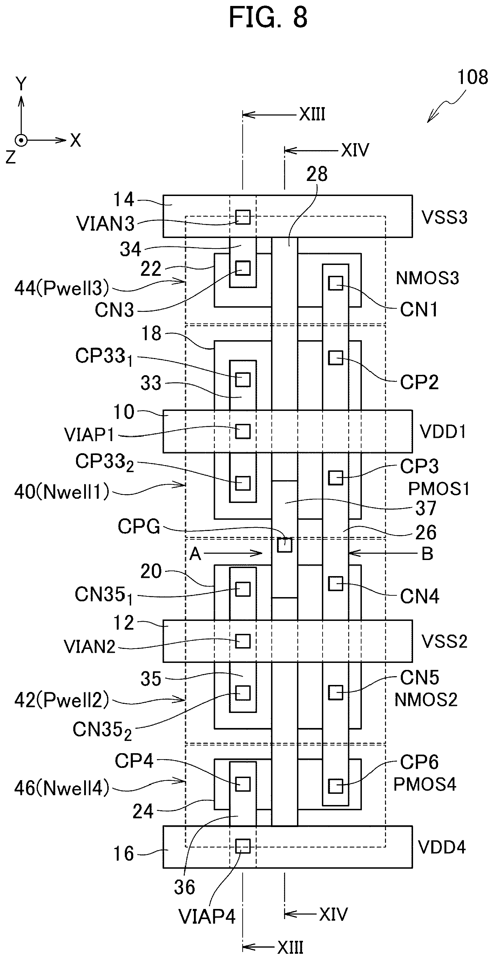

Fig. 8 is a planar pattern configuration diagram illustrating a semiconductor integrated circuit 108 according to a fourth embodiment. The semiconductor integrated circuit 108 according to the fourth embodiment is a triple height standard cell and corresponds to a pattern configuration of a CMOS inverter. The output OUT which can be represented to be similar to that of Fig. 1 is not illustrated in Fig. 8.

As illustrated in Fig. 8, the semiconductor integrated circuit 108 according to the fourth embodiment includes a first power supply line 10, a second power source line 12, a third power source line 14, and the fourth power source line 16. The first power supply line 10 and the second power source line 12 are disposed to extend in the X direction and to be separated from each other. The third power source line 14 is disposed to be adjacent to and in parallel to the first power supply line 10 in the Y direction orthogonal to the X direction, and has an electric potential equivalent to that of the second power source line 12. The fourth power source line 16 is disposed to be adjacent to and in parallel to the second power source line 12 in the minus Y direction, and has an electric potential equivalent to that of the first power supply line 10.

As illustrated in Fig. 8, the semiconductor integrated circuit 108 according to the fourth embodiment includes a first transistor PMOS1, a second transistor NMOS2, a third transistor NMOS3, and a fourth transistor PMOS4. The first transistor PMOS1 is disposed below (i.e., in the minus Z direction of ) the first power supply line 10. The first transistor PMOS1 includes a first conductivity-type first active region 18 disposed to extend in the Y direction and the minus Y direction. The second transistor NMOS2 is disposed below (i.e., in the minus Z direction of) the second power source line 12. The second transistor NMOS2 includes a second conductivity-type second active region 20 disposed to extend in the Y direction and the minus Y direction. The third transistor NMOS3 is disposed between the first active region 18 and the third power source line 14 and includes a second conductivity-type third active region 22. The fourth transistor PMOS4 is disposed between the second active region 20 and the fourth power source line 16 and includes a first conductivity-type fourth active region 24.

As illustrated in Fig. 8, the semiconductor integrated circuit 108 according to the fourth embodiment includes an electrode 34, an electrode 36, an electrode 33, and an electrode 35, each extending in the Y direction. The electrode 34 electrically connects between the third active region 22 and the third power source line 14. The electrode 36 electrically connects between the fourth active region 24 and the fourth power source line 16. The electrode 33 is electrically connected to the first active region 18 through contact electrodes CP33₁ and CP33₂. The electrode 35 is electrically connected to the second active region 20 through contact electrodes CN35₁ and CN35₂. The electrode 33 is further electrically connected to the first power supply line 10 through a VIA electrode VIAP1. The electrode 35 is electrically connected to the second power source line 12 through a VIA electrode VIAN2.

Fig. 9 is a circuit representation of the semiconductor integrated circuit 108 according to the fourth embodiment. The semiconductor integrated circuit 108 according to the fourth embodiment can be represented as a parallel circuit between a first CMOS inverter composed of the first transistor PMOS1 and the second transistor NMOS2 and a second CMOS inverter composed of the fourth transistor PMOS4 and the third transistor NMOS3, as illustrated in Fig. 9. An input A is connected to an input electrode 37 connected to the control electrode 28. An output B is connected to a common electrode 26.

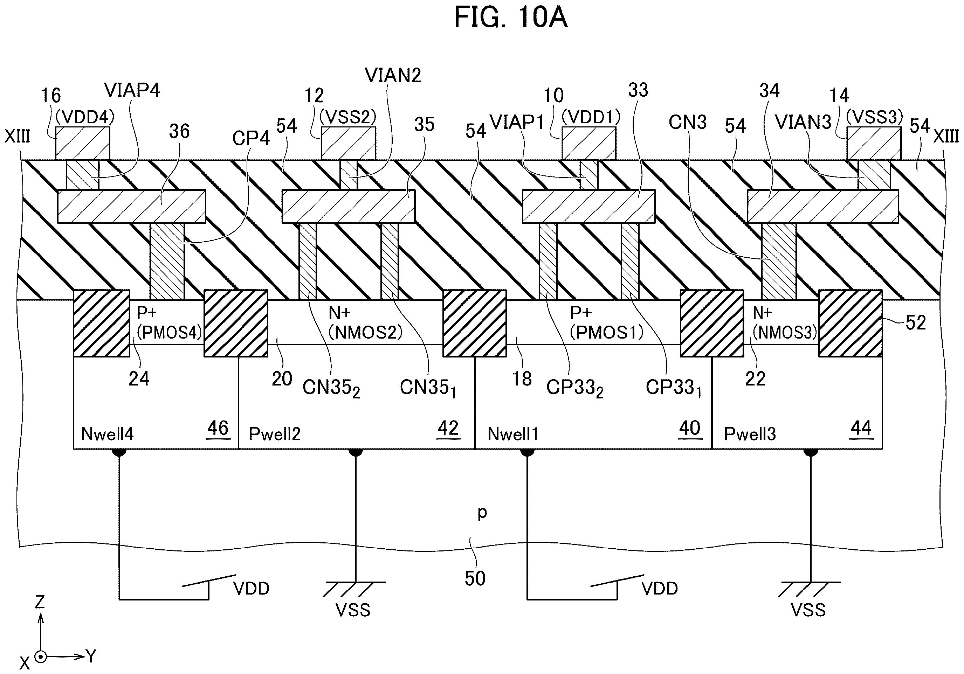

Fig. 10A is a cross-sectional diagram taken in the line XIII-XIII of Fig. 8. As illustrated in Figs. 8 and 10A, the semiconductor integrated circuit 108 according to the fourth embodiment includes a substrate 50, and a first well region 40, a second well region 42, a third well region 44, and a fourth well region 46, each disposed on the substrate 50. The first active region 18 is disposed on the first well region 40. The second active region 20 is disposed on the second well region 42. The third active region 22 is disposed on the third well region 44. The fourth active region 24 is disposed on the fourth well region 46. The contact electrodes CP33₁ and CP33₂ are disposed on the first active region 18. The contact electrodes CN35₁ and CN35₂ are disposed on the second active region 20. The contact electrode CN3 is disposed on the third active region 22. The contact electrode CP4 is disposed on the fourth active region 24. The electrode 33 is disposed on the contact electrodes CP33₁ and CP33₂, and the electrode 35 is disposed on the contact electrodes CN35₁ and CN35₂. The electrode 34 is disposed on the contact electrode CN3. The electrode 36 is disposed on the contact electrode CP4. The VIA electrode VIAP1 is disposed on the electrode 33. The VIA electrode VIAN2 is disposed on the electrode 35. The VIA electrode VIAN3 is disposed on the electrode 34. The VIA electrode VIAP4 is disposed on the electrode 36. The first power supply line 10 is disposed on the VIA electrode VIAP1. The second power source line 12 is disposed on the VIA electrode VIAN2. The third power source line 14 is disposed on the VIA electrode VIAN3. The fourth power source line 16 is disposed on the VIA electrode VIAP4.

The first active region 18 is electrically connected with the electrode 33 through the contact electrodes CP33₁ and CP33₂. Moreover, the second active region 20 is electrically connected to the electrode 35 through the contact electrodes CN35₁ and CN35₂. The electrode 33 is electrically connected to the first power supply line 10 through the VIA electrode VIAP1. The electrode 35 is electrically connected to the second power source line 12 through the VIA electrode VIAN2.

The third active region 22 is electrically connected to the electrode 34 through the contact electrode CN3. Moreover, the fourth active region 24 is electrically connected to the electrode 36 through the contact electrode CP4. The electrode 34 is electrically connected to the third power source line 14 through the VIA electrode VIAN3. The electrode 36 is electrically connected to the fourth power source line 16 through the VIA electrode VIAP4.

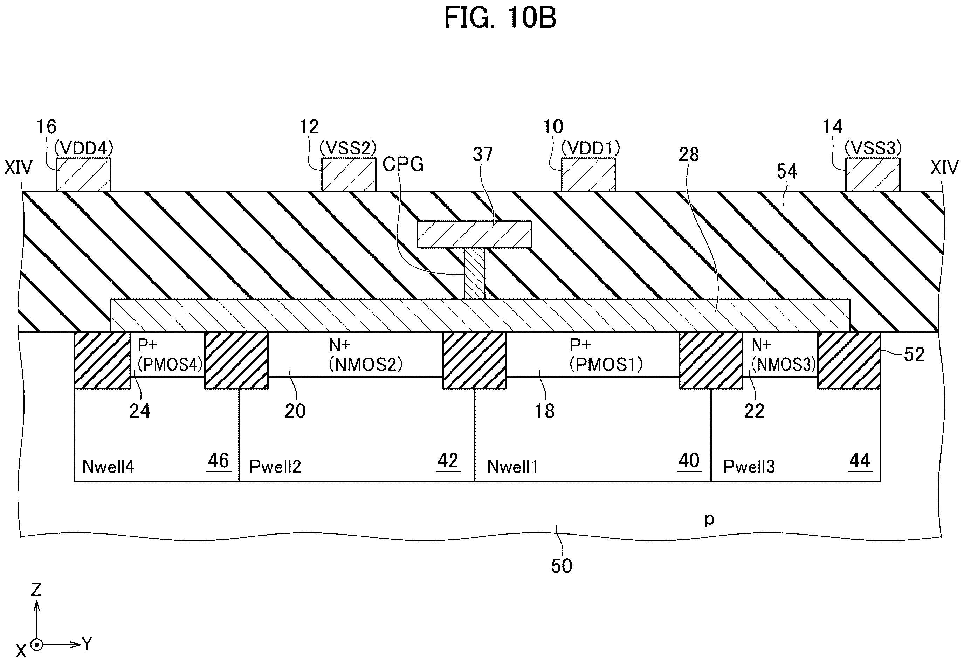

Fig. 10B is a cross-sectional diagram taken in the line XIV-XIV of Fig. 8. Fig. 10B corresponds to a structure cut along the control electrode 28 extending in the Y direction. As illustrated in Figs. 8 and 10B, the semiconductor integrated circuit 108 according to the fourth embodiment includes the control electrode 28 disposed to extend in the Y direction on the first active region 18, the second active region 20, the third active region 22, and the fourth active region 24. It is to be noted that a gate oxide film disposed between the control electrode 28, and the first active region 18, the second active region 20, the third active region 22, and the fourth active region 24 is not illustrated in the drawings. The first transistor PMOS1 includes the first active region 18 and the control electrode 28. The second transistor NMOS2 includes the second active region 20 and the control electrode 28. The third transistor NMOS3 includes the third active region 22 and the control electrode 28. The fourth transistor PMOS4 includes the fourth active region 24 and the control electrode 28. Moreover, as illustrated in Figs. 8 and 10B, the semiconductor integrated circuit 108 according to the fourth embodiment includes a contact electrode CPG disposed on the control electrode 28, and the input electrode 37 disposed on the contact electrode CPG. The input electrode 37 is electrically connected to the control electrode 28 through the contact electrode CPG.

As illustrated in Fig. 8, the semiconductor integrated circuit 108 according to the fourth embodiment includes a common electrode 26 connecting the first active region 18, the second active region 20, the third active region 22, and the fourth active region 24. An output of the logic circuit in the semiconductor integrated circuit 108 according to the fourth embodiment is obtained from the common electrode 26. The common electrode 26 and the first active region 18 are electrically connected to each other through the contact electrodes CP2 and CP3. The common electrode 26 and the second active region 20 are electrically connected to each other through the contact electrodes CN4 and CN5. The common electrode 26 and the third active region 22 are electrically connected to each other through a contact electrode CN1. The common electrode 26 and the fourth active region 24 are electrically connected to each other through a contact electrode CP6.

Moreover, with respect to the substrate 50, the common electrode 26, the input electrode 37, the electrode 33, the electrode 35, the electrode 34, and the electrode 36 are disposed as a first metal layer, and the first power supply line 10, the second power source line 12, the third power source line 14, and the fourth power source line 16 are disposed as a second metal layer. An interlayer insulation film 54 is disposed each between the substrate 50 and the common electrode 26 and between the substrate 50 and the first power supply line 10, the second power source line 12, the third power source line 14, and the fourth power source line 16.

As illustrated in Figs. 8 and 10A, in the semiconductor integrated circuit 108 according to the fourth embodiment, the first well region 40 and the fourth well region 46 are connected to the voltage VDD having an electric potential equivalent to the first power supply line 10 and the fourth power source line 16, and the second well region 42 and the third well region 44 are connected to the voltage VSS having an electric potential equivalent to the second power source line 12 and the third power source line 14.

The semiconductor integrated circuit 108 according to the fourth embodiment forms a triple-height CMOS inverter cell by disposing the third transistor NMOS3 and the fourth transistor PMOS4 with respect to the double-height cell structure composed of the first transistor PMOS1 and the second transistor NMOS2. Accordingly, an unused region that is an inactive region in the double-height cell structure can be used as the third active region 22 and the fourth active region 24, thereby improving area efficiency of the cell pattern in the standard cell.

### (Electromigration)

Electromigration is a phenomenon in which a shape of material is damaged by gradual movement of ions due to exchange of momentum between electrons and metal atoms moving in an electrical conductor. An effect thereof is greater as the current density is higher. As integrated circuits become microfabricated, the effect thereof cannot be ignored.

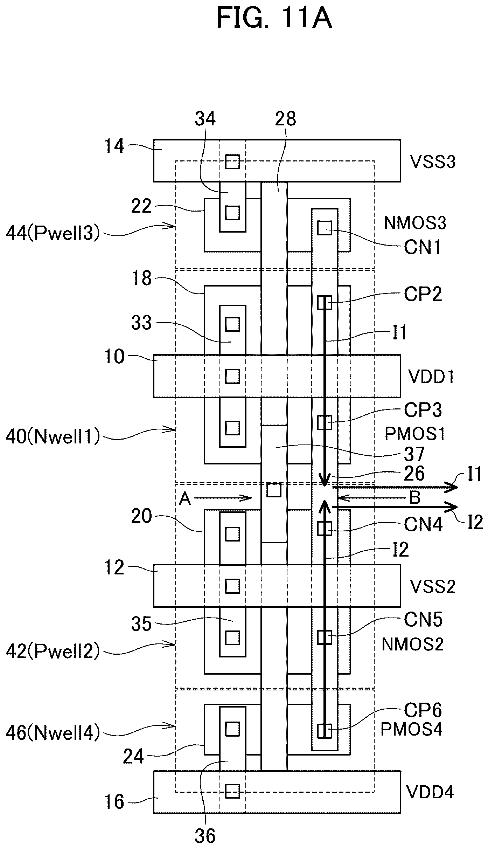

Fig. 11A is an explanatory diagram illustrating a current path in a case of providing a high level signal in Fig. 8. When the high level signal is provided, as illustrated in Fig. 11A, an electric current I1 flows from the drain voltage VDD of the first transistor PMOS1 toward the output B. Moreover, an electric current 12 flows from the drain voltage VDD of the fourth transistor PMOS4 toward the output B.

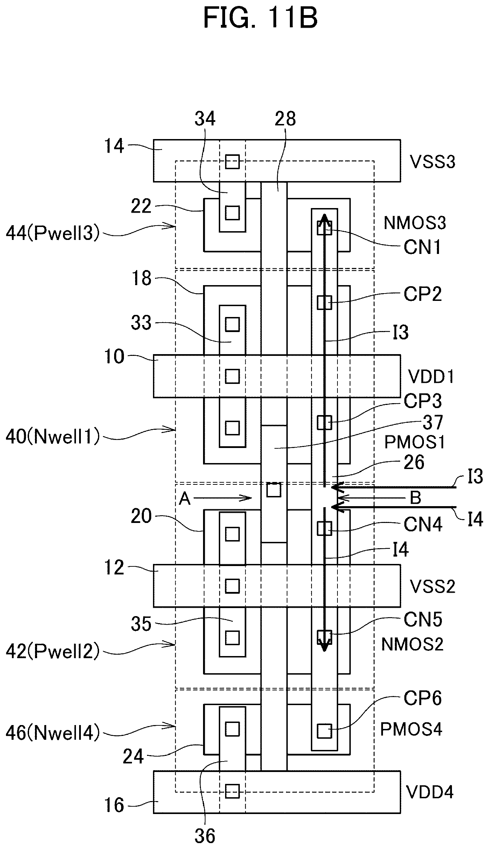

Fig. 11B is an explanatory diagram illustrating a current path in a case of providing a low level signal in Fig. 8. When the low level signal is provided, as illustrated in Fig. 11B, an electric current 14 flows from the output B toward the source voltage VSS of the second transistor NMOS2. Moreover, an electric current 13 flows the output B toward the source voltage VSS of the third transistor NMOS3 from.

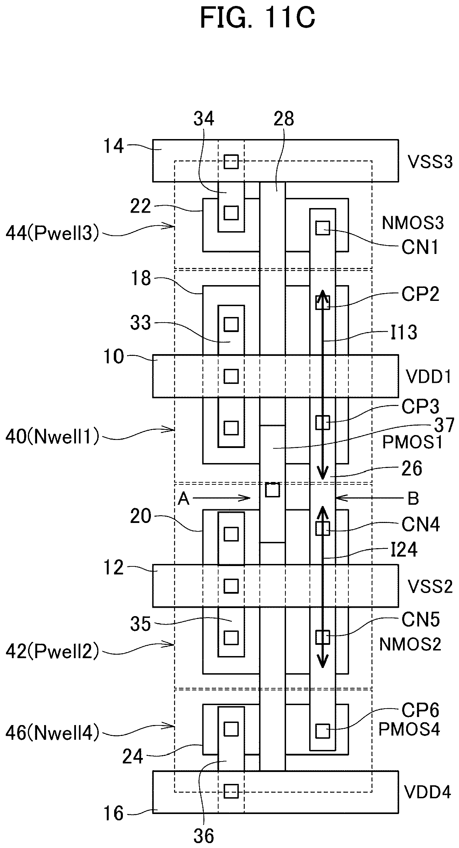

Fig. 11C is an explanatory diagram illustrating a suppressing operation of an electromigration (EM) in Fig. 8. In Fig. 8, in the electric currents I1 and 12 when the high level signal is provided and the electric currents 13 and 14 when the low level signal is provided, the electric currents flow in both directions in the portions indicated by the bidirectional arrows 113 and 124, as shown in Fig. 11C. Repeated providing the high level signal / low level signal improves electromigration by returning electrons. Since the number of the portions through which the currents flow in both the plus Y direction and the minus Y direction increases on the common electrode 26 , the electromigration is improved.

### (Effects of Fourth Embodiment)

With the semiconductor integrated circuit according to the fourth embodiment, the area efficiency of the cell pattern of standard cell in the CMOS inverter can be improved. Moreover, the electromigration can be improved.

### (Modified Examples of Fourth Embodiment)

A semiconductor integrated circuit according to a first modified example of the fourth embodiment can also include a configuration in which the third active region 22 is connected to the first power supply line 10, the fourth active region 24 is connected to the second power source line 12, and the capacitors are respectively connected to the first power supply line 10 and the second power source line 12 which are disposed at the center in the Y direction in the standard cell, for example, in the same manner as the second embodiment illustrated in Fig. 4. In this case, the common electrode 26 is not connected to the third active region 22 and the fourth active region 24, and is connected to the first active region 18 and the second active region 20, in the same manner as Fig. 4. This is for securing the circuit configuration of the CMOS inverter by the first transistor PMOS1 and the second transistor NMOS2. Alternatively, a semiconductor integrated circuit according to a second modified example of the fourth embodiment can also include a configuration in which the common electrode 26 is not connect to the third active region 22 and the fourth active region 24, and is connected to the first active region 18 and the second active region 20, for example, in the same manner as the third embodiment illustrated in Fig. 6A.

### (Effects of Modified Examples of Fourth Embodiment)

Also, with the semiconductor integrated circuit according to the modified examples of the fourth embodiment, the area efficiency of the cell pattern of standard cell in the CMOS inverter can be improved. Moreover, the circuit speed and operational stability can be improved by disposing the capacitors in the standard cell in the CMOS inverter. Moreover, the electromigration can be improved.

### (Comparative Example)

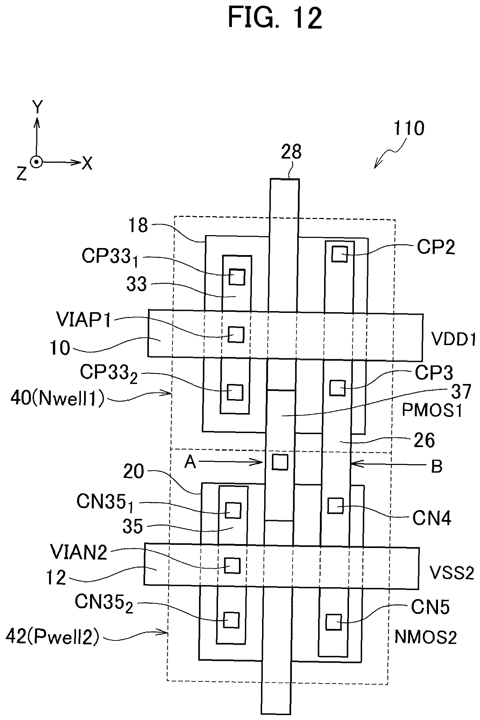

Fig. 12 is a planar pattern configuration diagram illustrating a semiconductor integrated circuit 110 according to a comparative example. The semiconductor integrated circuit 110 according to the comparative example includes a double-height standard cell and corresponds to a pattern configuration of a CMOS inverter.

The semiconductor integrated circuit 110 according to the comparative example includes a first power supply line 10 and a second power source line 12, as illustrated in Fig. 12. The first power supply line 10 and the second power source line 12 are disposed to extend in the X direction and to be separated from each other.

Furthermore, the semiconductor integrated circuit 110 according to the comparative example includes a first transistor PMOS1 and a second transistor NMOS2, as illustrated in Fig. 12. The first transistor PMOS1 is disposed below (i.e., in the minus Z direction of ) the first power supply line 10. The first transistor PMOS1 includes a first conductivity-type first active region 18 disposed to extend in the Y direction and the minus Y direction. The second transistor NMOS2 is disposed below (i.e., in the minus Z direction of) the second power source line 12. The second transistor NMOS2 includes a second conductivity-type second active region 20 disposed to extend in the Y direction and the minus Y direction.

The semiconductor integrated circuit 110 according to the comparative example includes an electrode 33 and an electrode 35, each extending in the Y direction, as illustrated in Fig. 12. The electrode 33 is electrically connected to the first active region 18 through contact electrodes CP33₁ and CP33₂. The electrode 35 is electrically connected to the second active region 20 through contact electrodes CN35₁ and CN35₂. The electrode 33 is further electrically connected to the first power supply line 10 through a VIA electrode VIAP1. The electrode 35 is electrically connected to the second power source line 12 through a VIA electrode VIAN2.

Fig. 13 is a circuit representation of the semiconductor integrated circuit 110 according to the comparative example. The semiconductor integrated circuit 110 according to the according to the comparative example can be represented as a CMOS inverter composed of the first transistor PMOS1 and the second transistor NMOS2, as illustrated in Fig. 13.

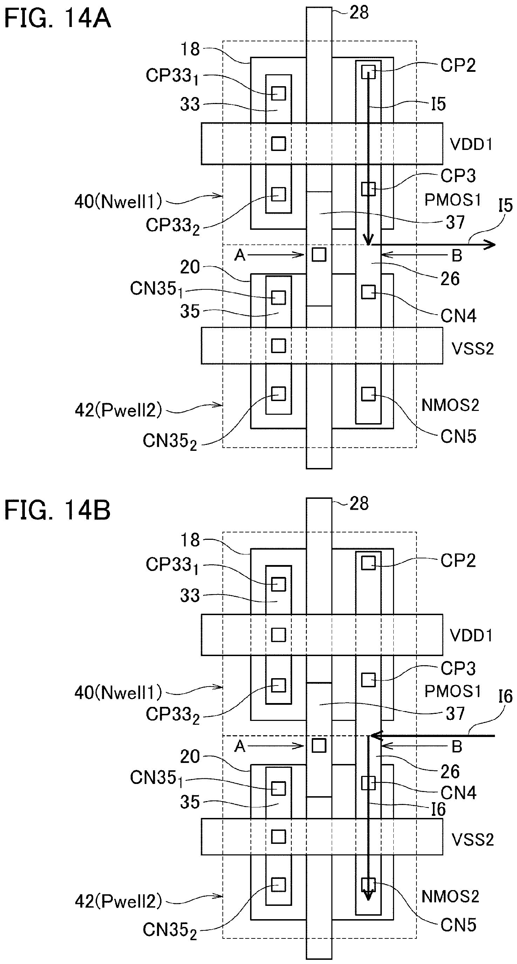

Fig. 14A is an explanatory diagram of a conduction path in the case of providing a high level signal in Fig. 13. When the high level signal is provided, as illustrated in Fig. 14A, an electric current 15 flows from the drain voltage VDD of the first transistor PMOS1 toward the output B.

Fig. 14B is an explanatory diagram of a conduction path in a case of providing a low level signal in Fig. 13. When the low level signal is provided, as illustrated in Fig. 14B, an electric current 16 flows from the output B toward the source voltage VSS of the second transistor NMOS2. In the semiconductor integrated circuit 110 according to the comparative example, there is almost no path through which the electric current bidirectionally flows but flows only in one direction even if providing both the high level signal / low level signal. Electromigration is deteriorated since electrons remain mobile in one direction.

### (Configuration Example of Standard Cell)

The semiconductor integrated circuit according to the embodiments constitutes a standard cell. The standard cell is disposed in the X direction and the Y direction. The standard cell constitutes a logic gate cell. The logic integrated circuit can be applied, for example, AND, OR, NAND, NOR, XOR, an inverter, an AND-OR inverter (AOI), an OR-AND inverter (OAI), a multiplexer (MUX), a flip-flop, a buffer gate, a latch gate, a delay cell, and a clock cell. Moreover, the standard cell may constitute a memory cell. As the memory cell, it can be applied, for example, a Static Random Access Memory (SRAM), a Dynamic Random Access Memory(DRAM), a Resistive Random Access Memory (ReRAM), a Phase Change Memory (PCM), a Magnetic Random Access Memory (MRAM), a Read Only Memory (ROM), etc. The semiconductor integrated circuit according to the embodiments may includes one or more active elements or passive elements. A transistor and a diode are included as an example of the active element. The transistor includes an MOS transistor, a CMOS transistor, a Bipolar Junction Transistor (BJT),a high voltage transistor, a high frequency transistor, a p channel FET, an n channel FET, a Fin FET, and the like. A capacitor, an inductor, a fuse, a resistor, and the like are included as an example of the passive element. The standard cell also includes logic circuits of various configurations other than those illustrated in the drawings.

The improvement effects of electromigration have been described using the example of the semiconductor integrated circuit according to the fourth embodiment and the modified examples thereof, but any portions of the common electrode where there are regions where the electric current flows bidirectionally have the same improvement effects of electromigration. Therefore, the same effects are realized also in the semiconductor integrated circuits according to the first to third embodiments. The same effects are also applied to the various standard cells described above to which the semiconductor integrated circuit according to the embodiments is applied.

While certain embodiments have been described, these embodiments have been presented by way of examples only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions. In some embodiments, for example, the first conductivity type and the second conductivity type may be formed as opposite conductivity types.

## Claims

1. A semiconductor integrated circuits designed by a standard cell layout where power source lines and active regions are disposed, **characterized in that** the semiconductor integrated circuits comprising:
a first power supply line (10 (VDD1)) and a second power source line (12 (VSS2)) disposed to extend in a first direction (X) and to be separated from each other;
a third power source line (14 (VSS3)) disposed to be adjacent to and in parallel to the first power supply line (10) in a second direction (Y) orthogonal to the first direction(X), the third power source line (14) having an electric potential equivalent to that of the second power source line (12);
a fourth power source line (16 (VDD4)) disposed to be adjacent to and in parallel to the second power supply line (12) in a minus direction (-Y) of the second direction, the fourth power source line (16) having an electric potential equivalent to that of the first power source line (10);
a first transistor (PMOS1) disposed below the first power supply line (10), first transistor (PMOS1) including a first conductivity-type first active region (18) extending in the second direction (Y) and the minus direction (-Y) of the second direction;
a second transistor (NMOS2) disposed below the second power source line (12), the second transistor (NMOS2) including a second conductivity-type second active region (20) extending in the second direction (Y) and the minus direction (-Y) of the second direction;
a third transistor (NMOS3) disposed between the first active region (18) and the third power source line (14), the third transistor (NMOS3) including a second conductivity-type third active region (22); and
a fourth transistor (PMOS4) disposed between the second active region (20) and the fourth power source line (16), the fourth transistor (PMOS4) including a first conductivity-type fourth active region (24).

2. The semiconductor integrated circuits according to claim 1, further comprising:
a substrate (50);
a second conductivity-type first well region (40 (Nwell)) disposed on the substrate (50), the first well region (40) including the first active region (18);
a first conductivity-type second well region (42 (Pwel2)) disposed on the substrate (50), the second well region (42) including the second active region (20);
a first conductivity-type third well region (44 (Pwel3)) disposed on the substrate (50), the third well region (44) including the third active region (22); and
a second conductivity-type fourth well region (46 (Nwel4)) disposed on the substrate (50), the fourth well region (46) including the fourth active region (24).

3. The semiconductor integrated circuits according to claim 2, further comprising
a first common electrode (26) connecting the first active region (18), the second active region (20), the third active region (22), and the fourth active region (24).

4. The semiconductor integrated circuits according to claim 2, further comprising:
a first electrode (30) extending in the second direction (Y) and electrically connecting between the third active region (22) and the first power supply line (10); and
a second electrode (32) extending in the minus direction (-Y) of the second direction and electrically connecting between the fourth active region (24) and the second power source line (12), wherein
the third active region (22) forms a first capacitor between third active region and the third well region (44), the third well region (44) has the electric potential equivalent to that of the third power source line (14), and
the fourth active region (24) forms a second capacitor between the fourth active region and the fourth well region (46), the fourth well region (46) has the electric potential equivalent to that of the fourth power source line (16).

5. The semiconductor integrated circuits according to claim 2, further comprising:
a third electrode (34) extending in the minus direction (-Y) of the second direction and electrically connecting between the third active region (22) and the third power source line (14); and
a fourth electrode (36) extending in the second direction (Y) and electrically connecting between the fourth active region (24) and the fourth power source line (16), wherein
the third active region (22) forms a third capacitor between third active region and the third well region (44), the third well region (44) has the electric potential equivalent to that of the third power source line (14), and
the fourth active region (24) forms a fourth capacitor between the fourth active region and the fourth well region (46), the fourth well region (46) has the electric potential equivalent to that of the fourth power source line (16).

6. The semiconductor integrated circuits according to claim 4 or 5, further comprising
a second common electrode (26, 26A) connecting between the first active region (18) and the second active region (20).

7. The semiconductor integrated circuits according to claim 5, further comprising
a third common electrode (26B) connecting the first active region (18), the second active region (20), the third active region (22), and the fourth active region (24).

8. The semiconductor integrated circuits according to claim 3, wherein
with respect to the substrate (50), the first common electrode (26) is disposed as a first metal layer, and the first power supply line (10), the second power source line (12), the third power source line (14), and the fourth power source line (16) are disposed as a second metal layer.

9. The semiconductor integrated circuits according to claim 6, wherein
with respect to the substrate (50), the second common electrode (26), the first electrode (30), and the second electrode (32) are disposed as a first metal layer, and the first power supply line (10), the second power source line (12), the third power source line (14), and the fourth power source line (16) are disposed as a second metal layer.

10. The semiconductor integrated circuits according to claim 6, wherein
with respect to the substrate (50), the second common electrode (26A), the third electrode (34), and the fourth electrode (36) are disposed as a first metal layer, and the first power supply line (10), the second power source line (12), the third power source line (14), and the fourth power source line (16) are disposed as a second metal layer.

11. The semiconductor integrated circuits according to claim 7, wherein
with respect to the substrate (50), the third common electrode (26B), the third electrode (34), and the fourth electrode (36) are disposed as a first metal layer, and the first power supply line (10), the second power source line (12), the third power source line (14), and the fourth power source line (16) are disposed as a second metal layer.

12. The semiconductor integrated circuits according to claim 1, further comprising
a first control electrode (28₂) disposed to extend in the second direction (Y) on the first active region (18), the second active region (20), the third active region (22), and the fourth active region (24).

13. The semiconductor integrated circuits according to claim 12, further comprising
a second control electrode (28₁) and a third control electrode (28₃) which are disposed to be adjacent to and in parallel to the first control electrode (28₂) so as to extend in the second direction (Y).

14. The semiconductor integrated circuits according to claim 1, wherein
gate widths of the first transistor (PMOS1) and the second transistor (NMOS2) are greater than gate widths of the third transistor (NMOS3) and the fourth transistor (PMOS4).

15. The semiconductor integrated circuits according to claim 14, wherein
the gate widths of the first transistor (PMOS1) and the second transistor (NMOS2) are approximately 3 times larger than the gate widths of the third transistor (NMOS3) and the fourth transistor (PMOS4).
